# EUROPÄISCHE PATENTANMELDUNG

(11) **EP 0 590 363 A1**
(43) Veröffentlichungstag der Anmeldung: **06.04.1994**
(21) Anmeldenummer: 93114389.5
(22) Anmeldetag: 08.09.1993
(51) Int. Cl.: H03L 7/199

(54) **PLL-Schaltung**

(30) Priorität: 29.09.1992 DE 4232609
(71) Anmelder: ROBERT BOSCH GMBH, 70442 Stuttgart (DE)
(72) Erfinder: Bitar, Omar, D-12277 Berlin (DE)

(57) **Zusammenfassung**

Es wird eine PLL-Schaltung vorgeschlagen, welche dazu dient, bei einer Frequenzumschaltung die Zeit bis zum Einrasten (Einschwingzeit) tₓ der neuen Frequenz zu verkürzen und das Überschwingen der geteilten Schwingfrequenz (32) gegenüber der Soll-Frequenz (31) zu verringern. Die PLL-Schaltung umfaßt einen Referenz-Oszillator (10), einen VCO (16), wenigstens einen in seinem Teilerverhältnis umschaltbaren Frequenzteiler (11,12) und einen Phasendetektor (14). Der wenigstens eine Frequenzteiler (11,12) wird zu einem bestimmten Zeitpunkt (t₁) nach dem Umschalten des Teilerverhältnisses synchronisiert, wobei der bestimmte Zeitpunkt (t₁) dem Zeitpunkt entspricht, zu dem die geteilte Schwingfrequenz zum ersten Mal nach dem Umschalten des Teileverhältnisses annähernd gleich der Soll-Frequenz (31) ist.

## Beschreibung

### Stand der Technik

Die Erfindung geht aus von einer PLL-(Phase-Locked-Loop)-Schaltung nach der Gattung des Hauptanspruchs. Es ist aus dem Fachbuch "Einführung in die PLL-Technik", Horst Geschwinde, Seite 28, eine PLL-Schaltung bekannt, wie sie in einem Mehrkanal-Funkgerät z.B. zur Trägerfrequenzgeneration verwendbar ist. Die PLL-Schaltung umfaßt einen Oszillator, im folgenden Referenzoszillator genannt, zur Bereitstellung einer Referenzfrequenz, einen spannungsgesteuerten Oszillator, im folgenden VCO (Voltage controlled oszillator) genannt, einen oder mehrere Frequenzteiler, welche die am Ausgang des VCO abgreifbare Schwingfrequenz teilen, um die dabei erhaltene Schwingung mit der ebenfalls über einen Frequenzteiler geteilten Referenzschwingung bezüglich ihrer Phase und ihrer Frequenz zu vergleichen, einen Phasendiskriminator, der diesen Vergleich durchführt und ein Schleifenfilter, welches die Impulse des Phasendiskriminators in eine Gleichspannung umwandelt. Diese Gleichspannung dient als Steuerspannung für den VCO.

Die Frequenz des freischwingenden VCO-Oszillators (Schwingfrequenz) wird mit wenigstens einem der umschaltbaren Teiler auf eine feste Frequenz heruntergeteilt und zusammen mit einer hochkonstanten Vergleichsfrequenz, im folgenden Soll-Frequenz genannt, welche vom Referenzoszillator über einen diesem nachgeschalteten Frequenzteiler geliefert wird, dem Phasendiskriminator, auch Phasendetektor genannt, zugeführt. Diese Schaltung zeigt eine Umschaltcharakteristik, bei welcher erst nach einer längeren Einschwingzeit die geteilte Schwingfrequenz des Ausgangssignals gleich der Soll-Frequenz ist. Außerdem tritt ein großes Überschwingen der geteilten Schwingfrequenz gegenüber der Soll-Frequenz auf.

Weiter ist aus dem Datenbuch "IC's für industrielle Anwendungen - Funkgeräte", Siemens, Ausgabe 1989, eine programmierbare Bus-Interface/Control-Logik, im folgenden Steuerlogik genannt, bekannt, welche zur Ansteuerung der Frequenzteiler einer PLL-Schaltung, welche in einem integrierten PLL-Frequenzsynthesizer-IC (Typ Siemens TBB 206) auf dem Markt erhältlich ist, dient. Außerdem ist in dieser Beschreibung des TBB 206 auch ein Schleifenfilter gezeigt, welches an das IC anschließbar ist.

Ebenso ist ein programmierbarer Frequenzteiler (z.B der Baustein Motorola MC 14018 B Presettable Divide-by-N Counter) bekannt, welcher eine Reset-Leitung aufweist, über die der Teiler jederzeit zurückgesetzt werden kann.

### Vorteile der Erfindung

Die erfindungsgemäße PLL-Schaltung mit den kennzeichnenden Merkmalen des Hauptanspruchs hat demgegenüber den Vorteil, daß die geteilte Schwingfrequenz des Ausgangssignals nach einer wesentlich geringeren Einschwingzeit gleich der Soll-Frequenz ist. Als weiterer Vorteil ist anzusehen, daß die Höhe des Überschwingers der geteilten Schwingfrequenz gegenüber der Soll-Frequenz erheblich geringer ist. Dadurch steht der bisher für die Pufferung des Überschwingers verbrauchte Spannungsbereich als echte Nutzspannung für den VCO (Voltage controlled oszillator) zur Verfügung. Dadurch kann ein VCO mit einer geringeren Anstiegssteilheit in die Schaltung eingesetzt werden, woraus der Vorteil erwächst, daß sich der Signal-/Rauschabstand erhöht.

Durch die in den Unteransprüchen aufgeführten Maßnahmen sind vorteilhafte und zweckmäßige Weiterbildungen und Verbesserungen der im Hauptanspruch angegebenen PLL-Schaltung möglich.

Eine Sperrung des Phasendetektors wenigstens für die Zeitdauer der halben Periode eines Eingangssignals des Phasendetektors unmittelbar nach dem Synchronisieren führt den Vorteil mit sich, daß eventuelle unerwünschte Störimpulse bei der Synchronisation am Ausgang des Phasendetektors unterdrückt werden. Die Reduzierung der Zeitbedingung für den bestimmten Zeitpunkt vor allem für kleine Sprunghöhen hat den Vorteil, daß der Aufwand für eine Meß-und Komparatorschaltung entfällt, ohne zu große Abweichungen des fest vorgegebenen bestimmten Zeitpunkts vom tatsächlichen bestimmten Zeitpunkt zu erhalten.

Weitere Vorteile ergeben sich durch das Vorsehen mehrerer Synchronisierimpulse nacheinander, wodurch die Einschwingzeit zusätzlich verkürzt wird. Eine Nulldurchgangserkennungsvorrichtung an wenigstens einem Frequenzteiler reduziert den Schaltungsaufwand, da dieser Frequenzteiler nicht mehr rückgesetzt werden muß. Ein Schleifenfilter zwischen Phasendetektor und VCO glättet das Ausgangssignal des Phasendetektors und ergibt eine bessere Ansteuerung des VCO. Die Verminderung des im Schleifenfilter enthaltenen Widerstands dient in vorteilhafter Weise der Verringerung von Spannungsspitzen am Eingang des VCO, welche eine ungenaue Ansteuerung des VCO zur Folge haben können.

### Zeichnung

Ausführungsbeispiele der Erfindung sind in der Zeichnung dargestellt und in der nachfolgenden Beschreibung näher erläutert. Es zeigen:
Figur 1 ein Blockschaltbild der erfindungsgemäßen PLL-Schaltung mit Synchronisationsleitungen,
Figur 2 ein Blockschaltbild der erfindungsgemäßen PLL-Schaltung mit einer Nulldurchgangserkennungseinrichtung,
Figur 3 das Einschwingdiagramm mit den Verläufen der geteilten Schwingfrequenz und der Soll-Frequenz einer PLL-Schaltung nach dem Stand der Technik,
Figur 4 die Darstellung der Signale am Phasendetektor
Figur 5 das Einschwingdiagramm mit den Verläufen der geteilten Schwingfrequenz und der Soll-Frequenz der erfindungsgemäßen PLL-Schaltung.
Figur 6 das Schaltbild des Schleifenfilters mit Schaltvorrichtung

### Beschreibung der Ausführungsbeispiele

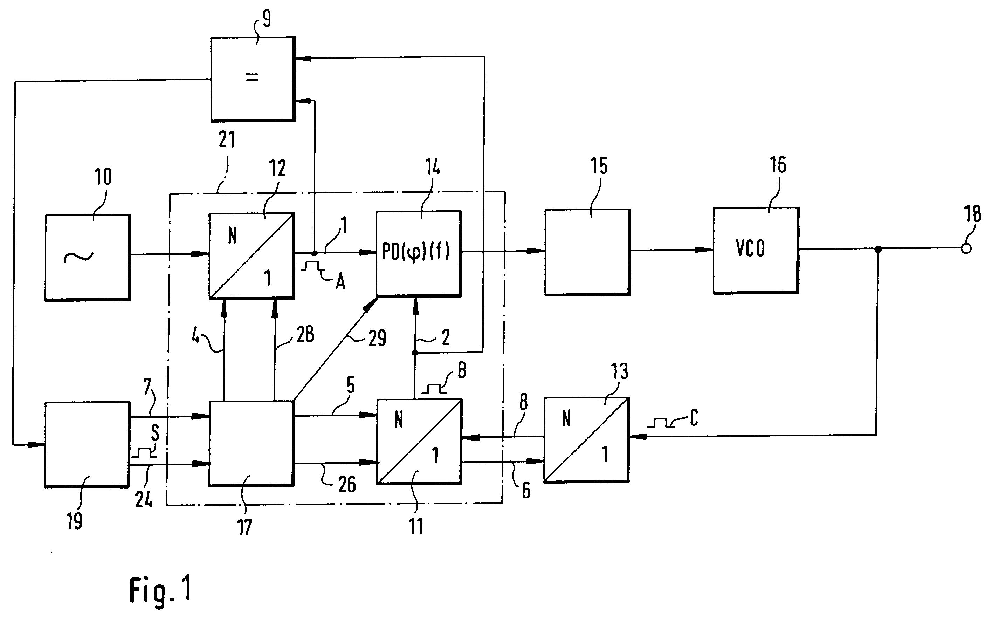

In Figur 1 ist eine erfindungsgemäße PLL-Schaltung dargestellt. Dabei wird einem Referenz-Oszillator 10 ein erster Frequenzteiler 12 nachgeschaltet. Der erste Frequenzteiler 12 erhält seine Steuersignale über eine Steuerleitung 4 von einer Steuerlogik 17, welche über eine zweite Steuerleitung 5 außerdem einen zweiten Frequenzteiler 11 ansteuert. Am Ausgang des ersten Frequenzteilers 12 ist ein Signal A auf einer Signalleitung 1 und am Ausgang des zweiten Frequenzteilers 11 ein weiteres Signal B auf einer weiteren Signalleitung 2 abgreifbar, welche beide einem Phasendetektor 14 zugeführt werden. Dem Phasendetektor 14 folgen nacheinander ein Schleifenfilter 15 und ein VCO 16, an dessen Ausgang, welcher den Schaltungsausgang 18 bildet, ein Ausgangssignal C abgegriffen und einem Vorteiler 13 zugeführt wird. Der Vorteiler 13 ist weiter über eine dritte Signalleitung 8 mit dem zweiten Frequenzteiler 11 verbunden, von dem außerdem eine dritte Steuerleitung 6 zum Vorteiler 13 läuft. Zur Ansteuerung der Steuerlogik 17 über eine vierte Steuerleitung 7 dient eine Eingabeeinrichtung 19, welche die Daten über den Umschaltvorgang an die Steuerlogik 17 übermittelt. Zwischen der Eingabeeinrichtung 19 und der Steuerlogik 17 ist eine Synchronisationsleitung 24 vorgesehen. Eine weitere Synchronisationsleitung 28 befindet sich zwischen der Steuerlogik 17 und dem ersten Frequenzteiler 12 sowie eine dritte Synchronisationsleitung 26 zwischen der Steuerlogik 17 und dem zweiten Frequenzteiler 11. Des weiteren führt eine Sperrleitung 29 von der Steuerlogik 17 zum Phasendetektor 14. Außerdem sind die Signale A, B an je einen Eingang eines Frequenzvergleichers 9 geführt, wo deren Frequenzen miteinander verglichen werden. Der Ausgang des Frequenzvergleichers 9 ist mit einem Eingang der Eingabeeinrichtung 19 verbunden. Die Eingabeeinrichtung 19 und die Steuerlogik 17 bilden zusammen eine Synchronisationseinrichtung 23.

Es ist möglich, die Frequenzteiler 11, 12, den Phasendetektor 14 und die Steuerlogik 17 in einer monolithisch integrierten Schaltung 21 zusammenzufassen. Die Schaltung ist beispielsweise zur Einstellung von Funkkanälen eines Funkgerätes einsetzbar.

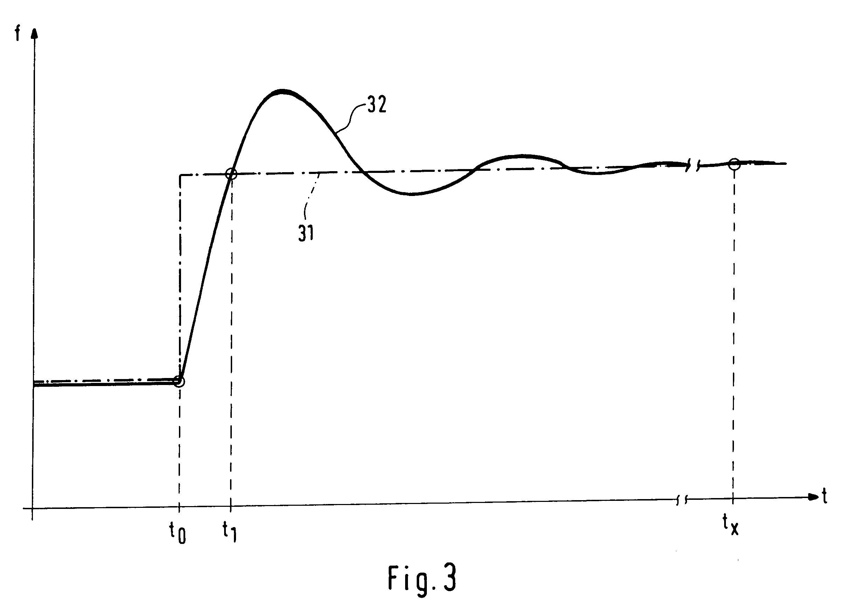

Die Funktionsweise der in Figur 1 dargestellten Schaltung wird anhand der Figuren 3, 4, und 5 erläutert. Während der erste Frequenzteiler 12 ein festes, von der Referenzfrequenz des Referenz-Oszillators 10 abhängiges, über die Steuerleitung 4 einstellbares Teilerverhältnis aufweist und der Vorteiler 13 ein festes über die dritte Steuerleitung 6 einstellbares Teilerverhältnis (z.B. 64/65) aufweist, wird das Teilerverhältnis des zweiten Frequenzteilers 11 zur Umschaltung des Funkkanals am Funkgerät über die zweite Steuerleitung 5, die Steuerlogik 17 und die vierte Steuerleitung 7 von der Eingabeeinrichtung 19 verändert. Dabei gibt die Eingabeeinrichtung 19 zu einem Umschaltzeitpunkt t₀ an die Steuerlogik 17 die Information, welcher Kanal eingestellt werden soll, weiter. Die Steuerlogik 17 enthält einen Speicher, der dem gewählten Kanal die zugehörigen Teilerfaktoren zuordnet und gibt die Teilerfaktoren an die Frequenzteiler 11, 12 weiter. Das vom Referenz-Oszillator 10 abgegebene Signal wird über den ersten Frequenzteiler 12 geteilt und dann über die Signalleitung 1 dem Phasendetektor 14 zugeführt, der dieses Signal A mit dem vom zweiten Frequenzteiler 11 gelieferten weiteren Signal B bezüglich ihrer Frequenz- und Phasenlage vergleicht. Das weitere Signal B resultiert aus dem Ausgangssignal des Phasendetektors 14, nachdem es über das Schleifenfilter 15, den VCO 16 und den Vorteiler 13 geführt wurde. Am Schaltungsausgang 18 ist das Ausgangssignal C nach einer Einschwingzeit tₓ stabil. Die PLL-Schaltung rastet in bekannter Weise ein (Phase locked), wenn die Frequenz und die Phase des Signals A annähernd gleich der Frequenz und der Phase des weiteren Signals B ist, was einer vorgegebenen Frequenztoleranz entspricht.

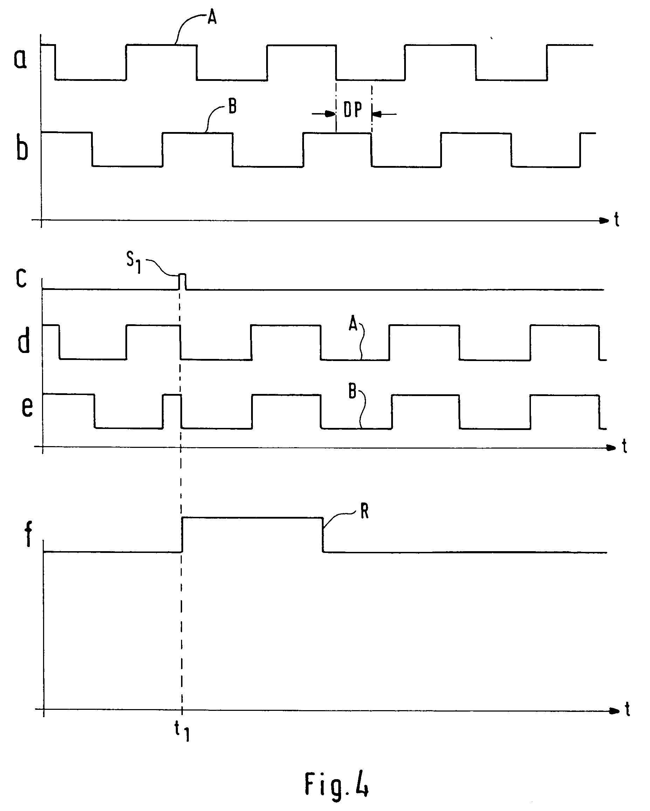

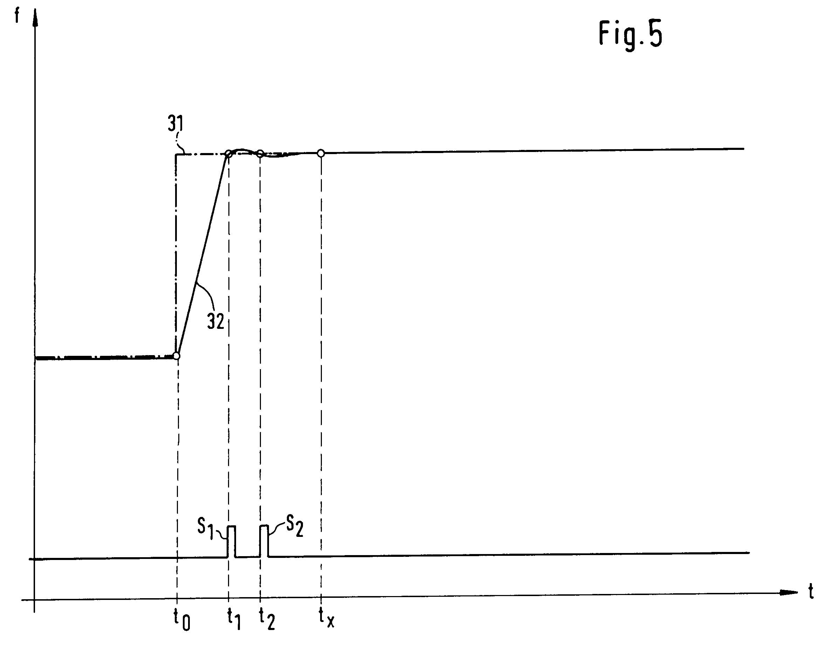

Während des Einschwingvorgangs bei einem Frequenzwechsel, wie er in Figur 3 dargestellt ist, tritt mit einer PLL-Schaltung nach dem Stand der Technik das Phänomen auf, daß, obwohl das in Figur 4b dargestellte weitere Signal B gleichfrequent zum in Figur 4a dargestellten Signal A schwingt, ein weiterer Frequenzanstieg des Ausgangssignals C und somit auch des davon abgeleiteten Signals B zu beobachten ist. Figur 3 zeigt diesen Fall, wobei die Frequenz des Signals B der geteilten Schwingfrequenz 32 entspricht, während die Frequenz des Signals A der Soll-Frequenz 31 entspricht. Dieses Phänomen begründet sich in der Phasendifferenz DP der Signale A und B, die in den Figuren 4a, 4b zu erkennen ist. Bei annähernder Frequenzgleichheit der Signale A, B gibt der Frequenzvergleicher 9 ein Gleichheitssignal an die Eingabeeinrichtung 19. Die Eingabeeinrichtung 19 gibt daraufhin wenigstens einen ersten Synchronisationsimpuls S₁ (siehe Figur 4c) über die Synchronisationsleitung 24 an die Steuerlogik 17, von wo er über die Synchronisationsleitungen 26, 28 zu den Frequenzteilern 11, 12 gelangt. Dieser Synchronisationsimpuls S₁ erfolgt zu dem bestimmten Zeitpunkt t₁ (siehe Figur 5), zu dem die geteilte Schwingfrequenz 32 annähernd gleich der Soll-Frequenz 31 ist. Von der Eingabeeinrichtung 19 über die Steuerlogik 17 werden die Frequenzteiler 11, 12 phasensynchronisiert, indem die Phase auf 0 gesetzt wird. Figur 4d und Figur 4e zeigen, wie die Signale A, B eine neue Schwingung mit gleicher Frequenz und der Phasendifferenz DP = 0 beginnen. Zusätzlich erhält der Phasendetektor 14 ein, in Figur 4f dargestelltes, Sperrsignal R über die Sperrleitung 29, wobei das Sperrsignal R für wenigstens eine halbe Periodendauer eines der Signale A oder B an einem Sperreingang des Phasendetektors 14 angelegt wird. Diesem Sperreingang kann z.B. eine in der Zeichnung nicht gesondert dargestellte Sperrvorrichtung folgen. Die Sperrvorrichtung besteht z.B. aus einem UND-Gatter mit einem invertierten und einem nichtinvertierten Eingang. Das Sperrsignal R liegt dabei am invertierten Eingang. Der Ausgang des UND-Gatters ist auch der Ausgang des Phasendetektors 14. Das Sperrsignal R am Sperreingang bewirkt, daß der Phasendetektor 14 ein Ausgangssignal nicht abgeben kann. Die Zeitdauer des Sperrsignals R entnimmt die Steuerlogik 17 einem weiteren in ihr enthaltenen Speicher, welcher den einstellbaren Kanälen Periodendauern zuordnet. Der dadurch erzielte Verlauf der geteilten Schwingfrequenz 32 für einen Sprung einer Soll-Frequenz 31 ist in Figur 5 dargestellt. Nach der Synchronisation zum bestimmten Zeitpunkt t₁ mit dem Synchronisationsimpuls S₁ entsteht nur noch ein geringer Überschwinger, im Idealfall sogar gar keiner mehr. Zur Sicherheit erfolgt zum weiteren bestimmten Zeitpunkt t₂ eine weitere Synchronisation mittels des weiteren Synchronisationsimpulses S₂. wobei der weitere bestimmte Zeitpunkt t₂ dabei dadurch bestimmt ist, daß die geteilte Schwingfrequenz 32 zum weiteren Mal annähernd gleich der Soll-Frequenz 31 ist. Die Einschwingzeit tₓ ist damit wesentlich geringer als bisher. Es ist ebenfalls möglich, beliebig viele weitere Synchronisationsimpulse vorzusehen, wobei die weiteren Synchronisationszeitpunkte jeweils durch die Bedingung der weiteren annähernden Gleichheit von geteilter Schwingfrequenz 32 und Soll-Frequenz 31 definiert sind, wodurch eine kürzere Einschwingzeit tₓ erhalten wird. Ebenso ist es möglich, die PLL-Schaltung ohne den Frequenzvergleicher 9 auszuführen. Der bestimmte Zeitpunkt t₁ ist dann fest in der Eingabeeinrichtung 19 abgespeichert. Zur Festlegung des Wertes für den bestimmten Zeitpunkt t₁ kann in einer experimentellen Phase der Schaltungseinstellung das Eingangssignal des VCO 16 hochohmig abgegriffen werden, z.B. über einen hochohmigen Verstärker (CMOS-Operationsvertärker), und der bestimmte Zeitpunkt t₁ ermittelt werden. Die Mittelung mehrerer solcher Messungen ergibt einen groben Wert für den bestimmten Zeitpunkt t₁.

Im Betrieb kann dann eine In-situ-Optimierung erfolgen, d.h. durch Variation des bestimmten Zeitpunkts t₁ im Betrieb und Messung der Einschwingzeit tₓ wird empirisch der optimale bestimmte Zeitpunkt t₁ ermittelt. Dieser bestimmte Zeitpunkt t₁ kann als frequenzunabhängiger Wert in der Eingabeeinrichtung 19 abgespeichert werden, aber ebenso z.B. abhängig von der Höhe des Frequenzsprungs.

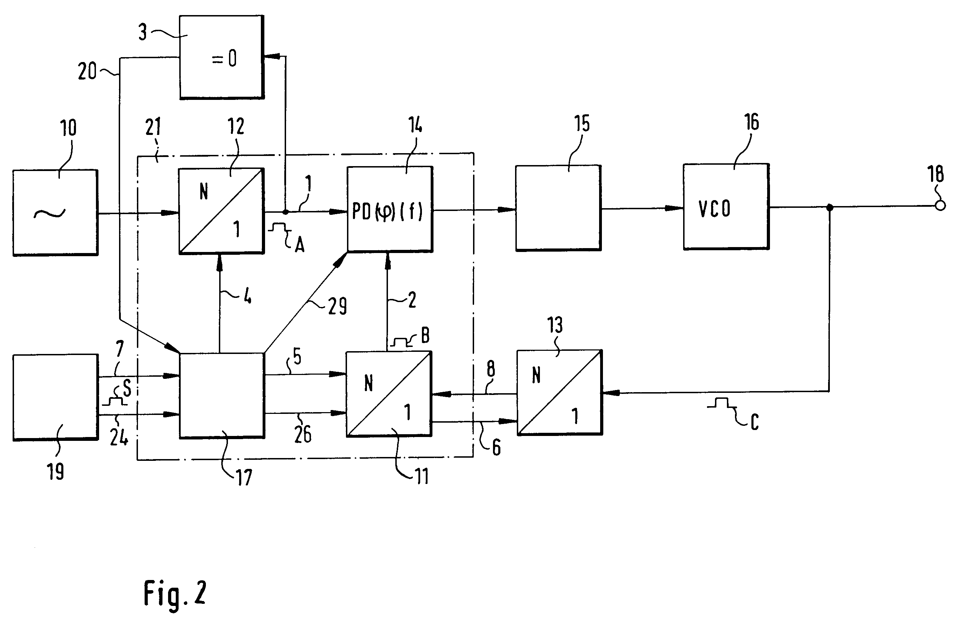

Das in Figur 2 gezeigte Blockschaltbild zeigt eine erfindungsgemäße PLL-Schaltung, welche sich von der in Figur 1 dargestellten Schaltung durch folgende Änderungen unterscheidet: Der Frequenzvergleicher 9 entfällt. Der Zeitpunkt, zu dem die geteilte Schwingfrequenz 32 zum ersten Mal nach dem Umschalten wenigstens eines der Frequenzteiler 11, 12 annähernd gleich der Soll-Frequenz 31 ist, ist fest in der Eingabeeinrichtung 19 abgespeichert. Des weiteren ist eine Nulldurchgangserkennungseinrichtung 3 an die Signalleitung 1 angeschlossen und über eine Nulldurchgangsmeldeleitung 20 mit der Steuerlogik 17 verbunden. Die weitere Synchronisationsleitung 28 entfällt ebenfalls.

Auf der Nulldurchgangsmeldeleitung 20 entsteht ein Signal, welches den Nulldurchgang der im ersten Frequenzteiler 12 produzierten Schwingung anzeigt. Für die Nulldurchgangserkennungseinrichtung 3 kann ein handelsüblicher Nulldurchgangsdetektor eingesetzt werden. Die Steuerlogik 17 wartet nach Erreichen des abgespeicherten Zeitpunkts den nächsten Nulldurchgang des Signals A ab, um dann das Signal B bzw. den zugehörigen zweiten Frequenzteiler 11 zu synchronisieren. Als bestimmter Zeitpunkt t₁, zu dem der Synchronisationsimpuls S₁ an die Frequenzteiler 11, 12 gelangt, dient also der Zeitpunkt des ersten Nulldurchgangs des Signals A, nachdem die geteilte Schwingfrequenz 32 zum ersten Mal nach dem Umschalten des Teilerverhältnisses zum Umschaltzeitpunkt t₀ annähernd gleich der Soll-Frequenz 31 ist .

Alternativ dazu kann die Nulldurchgangserkennungseinrichtung 3 auch als ein direkt an den ersten Frequenzteiler 12 angeschlossenes UND-Gatter ausgebildet sein, das den Zustand der im ersten Frequenzteiler 12 enthaltenen Zähler abfragt.
Insbesondere wenn die Referenzfrequenz ungeteilt am Phasendetektor 14 anliegt, ist die Schaltung gemäß Figur 2 unter Wegfall des ersten Frequenzteilers 12 einzusetzen.
Ebenso ist es möglich, den zuvor genannten hochohmigen Spannungsabgriff am Eingang des VCO 16 einem Vergleichsmittel zuzuführen, welches die abgegriffene Spannung mit dem von der Steuerlogik 17 ebenfalls dem Vergleichsmittel zugeführten Sollwert des Frequenzsprungs, welcher in einem f/u-Wandler zu dem entsprechenden Sollwert des Spannungssprungs umgewandelt wird, zu vergleichen und bei annähernder Gleichheit ein Signal zur Eingabeeinrichtung 19 zu übermitteln, welches diese wiederum zur Abgabe des Synchronisationsimpulses S₁ an die Synchronisationsleitung 24 veranlaßt.

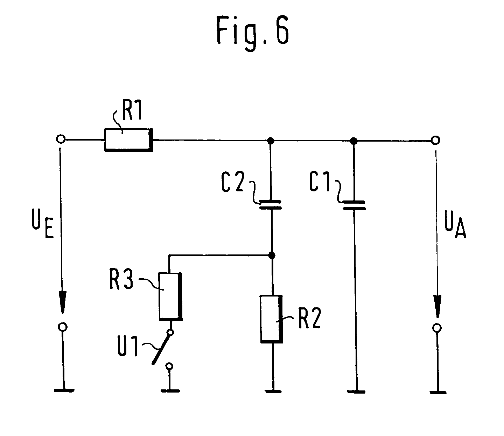

Figur 6 zeigt das Schaltbild des Schleifenfilters mit einer Schaltvorrichtung U₁ Die Schaltvorrichtung ist hier ein Schalter U₁. Der Eingangsspannung U_{E} liegt am Eingang des Schleifenfilters 15 an. Diesem folgt ein in Reihe geschalteter Widerstand R₁. Diesem folgt ein Kondensator C₁, der zum Eingang parallelgeschaltet ist. Ebenso parallelgeschaltet ist eine Serienschaltung aus einem weiteren Kondensator C₂ und einem weiteren Widerstand R₂. Zum weiteren Widerstand R₂ ist eine Serienschaltung aus dem Schalter U₁ und einem dritten Widerstand R₃ parallelgeschaltet. Parallel zum Kondensator C₁ ist eine Ausgangsspannung U_{A} abgreifbar.

Am Ausgang des Phasendetektors 14 erscheinen Spannungsimpulse mit der Soll-Frequenz 31. Die Impulsbreite ist eine Funktion der Phasendifferenz. Während der Impulsdauer laden sich die Kondensatoren C₁ und C₂ unterschiedlich auf und gleichen ihre Ladungen während der Impulspause zumindest teilweise wieder aus, was zu Spannungsspitzen der Ausgangsspannung U_{A} führt, wodurch der VCO 16 ungenau angesteuert wird. Durch ein Schließen des Schalters U₁, während der Einschwingphase zumindest bis zum bestimmten Zeitpunkt t₁ wird der weitere Widerstand R₂ verringert, wodurch der Spannungssunterschied der Kondensatoren C₁, C₂ geringer wird und damit auch die Spannungsspitzen kleiner werden. Der dritte Widerstand R₃ repräsentiert dabei einen beliebigen Wert, der insbesondere niedrig zu wählen ist. Die Ansteuerung des Schalters U₁ erfolgt zweckmäßigerweise durch die Steuerlogik 17, bzw. den Synchronisationsimpuls S₁ und Ausgestaltung des Schalters U₁ als elektronischer Schalter.

## Patentansprüche

1. PLL-Schaltung zur Erzeugung einer Schwingfrequenz an einem Schaltungsausgang, mit einem Referenz-Oszillator zur Erzeugung einer Referenzfrequenz, einem spannungsgesteuerten Oszillator zur Erzeugung der Schwingfrequenz, einem Phasendetektor, der die über wenigstens einen in seinem Teilerverhältnis umschaltbaren Frequenzteiler geteilte Schwingfrequenz mit einer Soll-Frequenz, die der über wenigstens einen weiteren in seinem Teilerverhältnis umschaltbaren Frequenzteiler geteilten Referenzfrequenz entspricht, vergleicht und den spannungsgesteuerten Oszillator ansteuert, dadurch gekennzeichnet, daß die Frequenzteiler (11, 12), die dem Phasendetektor (14) vorgeschaltet sind, Synchronisationseingänge aufweisen und daß eine Synchronisationseinrichtung (23) vorgesehen ist, die zu einem bestimmten Zeitpunkt (t₁) nach dem Umschalten des Teilerverhältnisses wenigstens eines Frequenzteilers (11, 12) einen Synchronisationsimpuls (S₁) an die Synchronisationseingänge der Frequenzteiler (11, 12) abgibt, wobei der bestimmte Zeitpunkt (t₁) dem Zeitpunkt entspricht, zu dem die geteilte Schwingfrequenz (32) zum ersten Mal nach dem Umschalten des Teilerverhältnisses wenigstens eines Frequenzteilers (11, 12) annähernd gleich der Soll-Frequenz (31) ist.

2. PLL-Schaltung nach Anspruch 1, dadurch gekennzeichnet, daß dem Ausgang des Phasendetektors (14) eine Sperrvorrichtung nachgeschaltet ist, die die Ausgabe des Ausgangssignals des Phasendetektors (14) unmittelbar nach dem bestimmten Zeitpunkt (t₁) für wenigstens eine halbe Periodendauer der am Phasendetektor (14) anliegenden Soll-Frequenz (31) oder der geteilten Schwingfrequenz (32) sperrt.

3. PLL-Schaltung nach einem der Ansprüche 1 oder 2, dadurch gekennzeichnet, daß der bestimmte Zeitpunkt (t₁) ein fest vorgegebener Wert ist.

4. PLL-Schaltung nach einem der Ansprüche 1 bis 3, dadurch gekennzeichnet, daß die Synchronisationseinrichtung (23) zu wenigstens einem weiteren bestimmten Zeitpunkt (t₂) einen weiteren Synchronisationsimpuls (S₂) an die Synchronisationseingänge der Frequenzteiler (11, 12) abgibt, wobei der wenigstens eine weitere bestimmte Zeitpunkt (t₂) dem Zeitpunkt entspricht, zu dem die geteilte Schwingfrequenz (32) zum wenigstens einen weiteren Mal nach dem Umschalten des Teilerverhältnisses wenigstens eines Frequenzteilers (11, 12) annähernd gleich der Soll-Frequenz (31) ist.

5. PLL-Schaltung nach Anspruch 4, dadurch gekennzeichnet, daß dem Ausgang des Phasendetektors (14) eine Sperrvorrichtung nachgeschaltet ist, die die Ausgabe des Ausgangssignals des Phasendetektors (14) unmittelbar nach dem wenigsten einen weiteren bestimmten Zeitpunkt (t₂) für wenigstens eine halbe Periodendauer der am Phasendetektor (14) anliegenden Soll-Frequenz (31) oder der geteilten Schwingfrequenz (32) sperrt.

6. PLL-Schaltung nach einem der Ansprüche 4 oder 5, dadurch gekennzeichnet, daß der wenigstens eine weitere bestimmte Zeitpunkt (t₂) ein fest vorgegebener Wert ist.

7. PLL-Schaltung zur Erzeugung einer Schwingfrequenz an einem Schaltungsausgang, mit einem Referenz-Oszillator zur Erzeugung einer Referenzfrequenz, einem spannungsgesteuerten Oszillator zur Erzeugung der Schwingfrequenz, einem Phasendetektor, der die über wenigstens einen in seinem Teilerverhältnis umschaltbaren Frequenzteiler geteilte Schwingfrequenz mit einer Soll-Frequenz, die der Referenzfrequenz oder der über wenigstens einen weiteren Frequenzteiler geteilten Referenzfrequenz entspricht, vergleicht und den Spannungsgesteuerten Oszillator ansteuert, dadurch gekennzeichnet, daß der Frequenzteiler (11), der dem Phasendetektor (14) vorgeschaltet ist, einen Synchronisationseingang aufweist und daß eine Synchronisationseinrichtung (23) vorgesehen ist, die zu einem bestimmten Zeitpunkt (t₁) nach dem Umschalten des Teilerverhältnisses wenigstens eines Frequenzteilers (11, 12) einen Synchronisationsimpuls (S₁) an den Synchronisationseingang des Frequenzteilers (11) abgibt, wobei der bestimmte Zeitpunkt (t₁) dem Zeitpunkt entspricht, zu dem das Signal mit der Soll-Frequenz (31) zum ersten Mal einen Nulldurchgang aufweist, nachdem die geteilte Schwingfrequenz (32) zum ersten Mal nach dem Umschalten des Teilerverhältnisses wenigstens eines Frequenzteilers (11, 12) annähernd gleich der Soll-Frequenz (31) ist.

8. PLL-Schaltung nach Anspruch 7, dadurch gekennzeichnet, daß dem Ausgang des Phasendetektors (14) eine Sperrvorrichtung nachgeschaltet ist, die die Ausgabe des Ausgangssignals des Phasendetektors (14) unmittelbar nach dem bestimmten Zeitpunkt (t₁) für wenigstens eine halbe Periodendauer der am Phasendetektor (14) anliegenden Soll-Frequenz (31) oder der geteilten Schwingfrequenz (32) sperrt.

9. PLL-Schaltung nach einem der Ansprüche 7 oder 8, dadurch gekennzeichnet, daß die Synchronisationseinrichtung (23) zu wenigstens einem weiteren bestimmten Zeitpunkt (t₂) einen weiteren Synchronisationsimpuls (S₂) an den Synchronisationseingang des Frequenzteilers (11) abgibt, wobei der wenigstens eine weitere bestimmte Zeitpunkt (t₂) dem Zeitpunkt entspricht, zu dem das Signal mit der Soll-Frequenz (31) zum ersten Mal einen Nulldurchgang aufweist, nachdem die geteilte Schwingfrequenz (32) zum wenigstens einen weiteren Mal nach dem Umschalten des Teilerverhältnisses wenigstens eines Frequenzteilers (11, 12) annähernd gleich der Soll-Frequenz (31) ist.

10. PLL-Schaltung nach Anspruch 9, dadurch gekennzeichnet, daß dem Ausgang des Phasendetektors (14) eine Sperrvorrichtung nachgeschaltet ist, die die Ausgabe des Ausgangssignals des Phasendetektors (14) unmittelbar nach dem wenigsten einen weiteren bestimmten Zeitpunkt (t₂) für wenigstens eine halbe Periodendauer der am Phasendetektor (14) anliegenden Soll-Frequenz (31) oder der geteilten Schwingfrequenz (32) sperrt.

11. PLL-Schaltung nach einem der Ansprüche 1 bis 10, dadurch gekennzeichnet, daß zwischen dem Phasendetektor (14) und dem spannungsgesteuerten Oszillator (16) ein Schleifenfilter (15) vorgesehen ist.

12. PLL-Schaltung nach Anspruch 11, dadurch gekennzeichnet, daß das Schleifenfilter (15) wenigstens eine Parallelschaltung aus einem Kondensator (C₁) und einer Serienschaltung eines weiteren Kondensators (C₂) und eines weiteren Widerstands (R₂) aufweist und daß der weitere Widerstand (R₂) mittels einer Schaltvorrichtung (U₁) wenigstens über die Zeitspanne vom Zeitpunkt des Umschaltens des Teilerverhältnisses wenigstens eines Frequenzteilers (11, 12) bis zum bestimmten Zeitpunkt (t₁) verringerbar ist.
